# EUROPEAN PATENT APPLICATION

(11) **EP 4 542 002 A2**
(43) Date of publication of application: **23.04.2025**
(21) Application number: 24207483.9
(22) Date of filing: 18.10.2024
(51) Int. Cl.: F01D 5/10, F01D 5/16, F01D 5/26, F01D 5/30

(54) **METHOD FOR PRODUCING A ROTOR BLADE WITH MOMENT WEIGHT DATA**

(30) Priority: 18.10.2023 US 202318381602
(71) Applicant: RTX Corporation, Farmington, CT 06032 (US)
(72) Inventor: RUSSELL, Jesse W., St. Johns, 48879 (US); ROOBOL, Jonathan, Howell, 48843 (US); HOLLAND, Brian K., Mason, 48854 (US); McCLELLAN, Ross A., Vernon, 06066 (US)
(74) Representative: Dehns

(57) **Abstract**

A method of producing a fan blade (52) with moment weight data is provided that includes: providing a primary master fan blade (PMFB) having a recorded PMFB moment weight value and a recorded PMFB weight value; using a moment weight machine (60) to determine a PMFB moment weight offset value for the primary master fan blade; providing a secondary master fan blade (SMFB); producing a SMFB statistical moment weight value using the moment weight machine; producing SMFB calibration values for the secondary master fan blade using the PMFB moment weight offset value and the SMFB statistical moment weight value; and using the SMFB calibration values and the secondary master fan blade to produce a fan blade with moment weight data.

## Description

### BACKGROUND OF THE INVENTION

### 1. Technical Field

The present disclosure relates to turbine engines in general and to methods for producing a rotor blade with moment weight data for use in a turbine engine rotor stage in particular.

### 2. Background Information

A fan blade rotor stage within a turbine engine includes a hub and a plurality of fan blades attached to the hub for rotation about an axis. The fan blades are disposed at circumferential positions around the hub and extend radially out from the hub. Turbine engine fan blades are very often significant in size and weight. During operation of the turbine engine, the fan blades are rotated within a range of rotational speeds; e.g., rotations per minute or "RPMs". At the high end of the range, the fan blade rotational speed can be significant. An imbalance within one or more fan blades within a fan blade stage may create undesirable vibrations and loadings associated with such vibrations. It would be desirable to provide an improved method for balancing fan blades.

### SUMMARY

According to an aspect of the present disclosure, a method of producing a fan blade with moment weight data is provided that includes: providing a primary master fan blade (PMFB) having a recorded PMFB moment weight value and a recorded PMFB weight value; using a moment weight machine to determine a PMFB moment weight offset value for the primary master fan blade; providing a secondary master fan blade (SMFB); producing a SMFB statistical moment weight value using the moment weight machine; producing SMFB calibration values for the secondary master fan blade using the PMFB moment weight offset value and the SMFB statistical moment weight value; and using the SMFB calibration values and the secondary master fan blade to produce a fan blade with moment weight data.

In any of the aspects or embodiments described above and herein, the step of using the SMFB calibration values and the secondary master fan blade to produce the fan blade with moment weight data may include using the SMFB calibration values and the secondary master fan blade to calibrate a second moment weight machine, and using the calibrated second moment weight machine to produce the fan blade with moment weight data.

In any of the aspects or embodiments described above and herein, the step of using the calibrated second moment weight machine to produce the fan blade (FB) with moment weight data may include using the second moment weight machine to determine a radial FB moment weight value for the fan blade, an axial FB moment weight value for the fan blade, and a tangential FB moment weight value for the fan blade.

In any of the aspects or embodiments described above and herein, the method may include comparing the radial FB moment weight value to a first threshold, or comparing the axial FB moment weight value to a second threshold, or comparing the tangential FB moment weight value to a third threshold.

In any of the aspects or embodiments described above and herein, the step of using the moment weight machine to determine the PMFB moment weight offset value may include using the moment weight machine to determine a plurality of measured PMFB moment weight values for the primary master fan blade, and producing a PMFB statistical moment weight value representative of the plurality of measured PMFB moment weight values.

In any of the aspects or embodiments described above and herein, the plurality of measured PMFB moment weight values may include a plurality of measured PMFB radial moment weight values, a plurality of measured PMFB axial moment weight values, and a plurality of measured PMFB tangential moment weight values.

In any of the aspects or embodiments described above and herein, the PMFB statistical moment weight value may include a first value representative of an average of the plurality of measured PMFB radial moment weight values, a second value representative of an average of the plurality of measured PMFB axial moment weight values, and a third value representative of an average of the plurality of measured PMFB tangential moment weight values.

In any of the aspects or embodiments described above and herein, the step of producing a SMFB statistical moment weight value may include using the moment weight machine to determine a plurality of measured SMFB moment weight values for the secondary master fan blade, and producing the SMFB statistical moment weight value using the plurality of measured SMFB moment weight values.

In any of the aspects or embodiments described above and herein, the plurality of measured SMFB moment weight values may include a plurality of measured SMFB radial moment weight values, a plurality of measured SMFB axial moment weight values, and a plurality of measured SMFB tangential moment weight values.

In any of the aspects or embodiments described above and herein, the SMFB statistical moment weight value may include a first value representative of an average of the plurality of measured SMFB radial moment weight values, a second value representative of an average of the plurality of measured SMFB axial moment weight values, and a third value representative of an average of the plurality of measured SMFB tangential moment weight values.

In any of the aspects or embodiments described above and herein, the method may include at least one of determining a maximum measured SMFB radial moment weight value from the plurality of measured SMFB radial moment weight values, a minimum measured SMFB radial moment weight value from the plurality of measured SMFB radial moment weight values, and a first difference value representative of a first difference between the maximum measured SMFB radial moment weight value and the minimum measured SMFB radial moment weight value, and comparing the first difference value to a first threshold value to determine an acceptability of the secondary master fan blade; or determining a maximum measured SMFB axial moment weight value from the plurality of measured SMFB axial moment weight values, a minimum measured SMFB axial moment weight value from the plurality of measured SMFB axial moment weight values, and a second difference value representative of a second difference between the maximum measured SMFB axial moment weight value and the minimum measured SMFB axial moment weight value, and comparing the second difference value to a second threshold value to determine the acceptability of the secondary master fan blade; or determining a maximum measured SMFB tangential moment weight value from the plurality of measured SMFB tangential moment weight values, a minimum measured SMFB tangential moment weight value from the plurality of measured SMFB tangential moment weight values, and a third difference value representative of a third difference between the maximum measured SMFB tangential moment weight value and the minimum measured SMFB tangential moment weight value, and comparing the third difference value to a third threshold value to determine the acceptability of the secondary master fan blade.

In any of the aspects or embodiments described above and herein, the step of producing SMFB calibration values may include a weight value based on a measured weight of the secondary master fan blade.

In any of the aspects or embodiments described above and herein, the method may include using the secondary master fan blade to calibrate the moment weight machine.

In any of the aspects or embodiments described above and herein, the primary master fan blade may be a tool that replicates a production fan blade.

In any of the aspects or embodiments described above and herein, the secondary master fan blade may be a tool that replicates a production fan blade.

According to an aspect of the present disclosure, a method of producing a fan blade with moment weight data is provided that includes: using a primary master fan blade (PMFB) having a recorded PMFB moment weight value and a recorded PMFB weight value and a first moment weight machine to produce a secondary master fan blade (SMFB) with SMFB calibration values; using the SMFB calibration values and the secondary master fan blade to calibrate a second moment weight machine; and using the calibrated second moment weight machine to produce a fan blade with moment weight data.

In any of the aspects or embodiments described above and herein, the step of using the calibrated second moment weight machine to produce the fan blade (FB) with moment weight data may include using the second moment weight machine to determine a radial FB moment weight value for the fan blade, an axial FB moment weight value for the fan blade, and a tangential FB moment weight value for the fan blade.

The foregoing features and elements may be combined in various combinations without exclusivity, unless expressly indicated otherwise. For example, aspects and/or embodiments of the present disclosure may include any one or more of the individual features or elements disclosed above and/or below alone or in any combination thereof. These features and elements as well as the operation thereof will become more apparent in light of the following description and the accompanying drawings. It should be understood, however, the following description and drawings are intended to be exemplary in nature and non-limiting.

### BRIEF DESCRIPTION OF THE DRAWINGS

FIG. 1 is a diagrammatic sectional view of a gas turbine engine.
FIG. 2 is a diagrammatic perspective view of a turbine engine fan blade.
FIG. 3 is a flow chart representing an embodiment of the present disclosure method.
FIG. 4 is a flow chart representing an embodiment of the present disclosure method.
FIG. 5 is a diagrammatic illustration of a moment weight machine.

### DETAILED DESCRIPTION

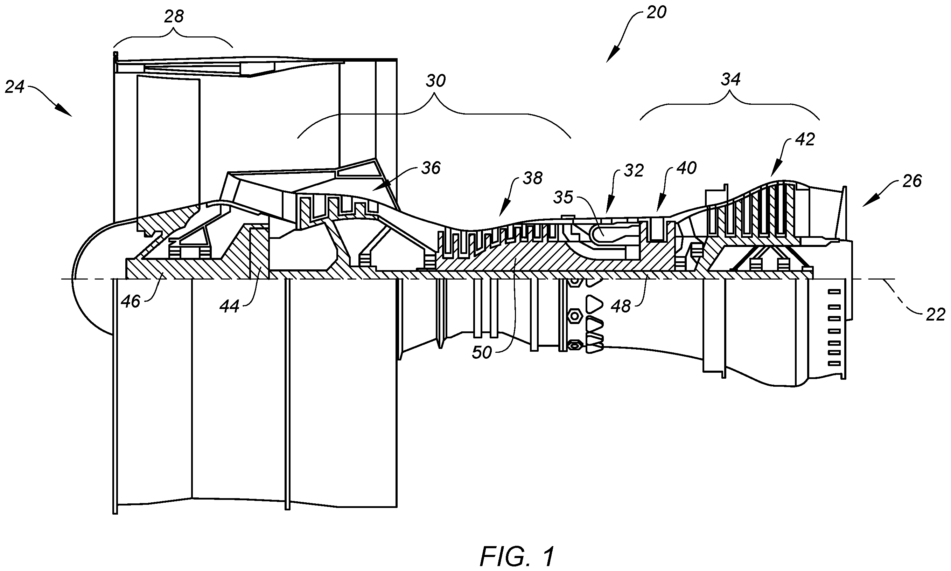

FIG. 1 shows a partially sectioned diagrammatic view of a geared gas turbine engine 20. The gas turbine engine 20 extends along an axial centerline 22 between an upstream air flow inlet 24 and a downstream air flow exhaust 26. The gas turbine engine 20 includes a fan section 28, a compressor section 30, a combustor section 32, and a turbine section 34. The combustor section 32 includes a combustor 35. The compressor section 30 includes a low pressure compressor (LPC) 36 and a high pressure compressor (HPC) 38. The turbine section 34 includes a high pressure turbine (HPT) 40 and a low pressure turbine (LPT) 42. The engine sections are arranged sequentially along the centerline 22. The fan section 28 is connected to a geared architecture 44, for example, through a fan shaft 46. The geared architecture 44 and the LPC 36 are connected to and driven by the LPT 42 through a low speed shaft 48. The HPC 38 is connected to and driven by the HPT 40 through a high speed shaft 50. The terms "forward", "leading", "aft, "trailing" are used herein to indicate the relative position of a component or surface. As core gas air passes through the engine 20, a "leading edge" of a stator vane or rotor blade encounters core gas air before the "trailing edge" of the same. In a conventional axial engine such as that shown in FIG. 1, the fan section 28 is "forward" of the compressor section 30 and the turbine section 34 is "aft" of the compressor section 30. The terms "inner radial" and "outer radial" refer to relative radial positions from the engine centerline 22. An inner radial component or path is disposed radially closer to the engine centerline 22 than an outer radial component or path. The gas turbine engine 20 diagrammatically shown is an example provided to facilitate the description herein. The present disclosure is not limited to any particular gas turbine engine configuration.

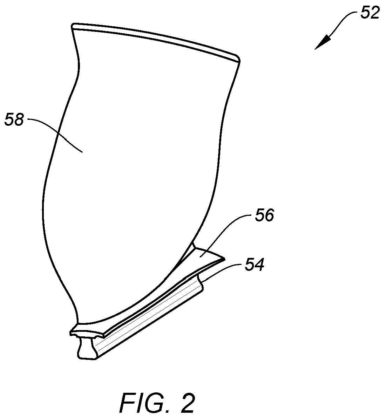

FIG. 2 diagrammatically illustrates a turbine engine fan blade 52 having a root 54, a platform 56, and an airfoil 58. The fan blade 52 shown in FIG. 2 is provided to illustrate an example of a fan blade 52. The present disclosure is not, however, limited to use with any particular turbine engine fan blade or rotor blade. The fan blades 52 may be mechanically connected to a hub (not shown) that is centered on a rotational axis; e.g., the root 54 of each fan blade 52 may be received within a corresponding slot disposed within the hub. During use, the rotor stage including the hub 54 and the fan blades 52 extending radially outward from the hub are rotated about the rotational axis.

Fan blades are manufactured to certain dimensional specifications. Most, if not all, of these specifications will have a tolerance range. If the blade dimensions are within the respective tolerance range, the fan blade is accepted. In view of the tolerance ranges, however, acceptable fan blades will physically vary. A fan stage within a turbofan gas turbine engine may rotate as fast as three thousand rpms. At such high rotational speeds, an unbalanced fan rotor stage can experience significant vibrational forces. The present disclosure provides a method that facilitates producing a fan rotor stage with improved balancing to mitigate undesirable vibrational forces.

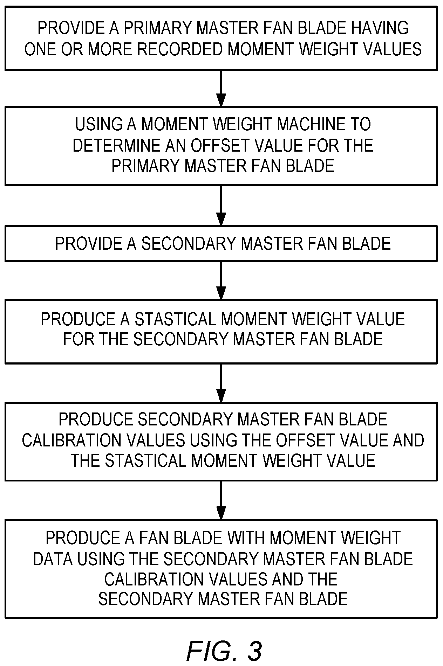

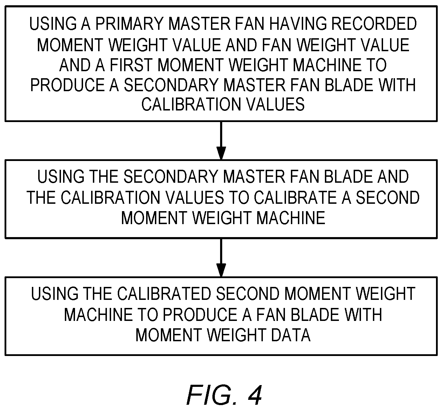

Referring to FIGS. 3 and 4, embodiments of the present disclosure include a method for producing a rotor blade (e.g., a fan blade) with moment weight data. To facilitate the description herein, the rotor blade is described as a turbine engine fan blade. The present disclosure may be used with any rotor blade that is utilized with moment weight data. Hence, the present disclosure method is not limited to use with turbine engine fan blades, although the present disclosure provides considerable utility when used to produce such fan blades. The methodology includes the selection of a primary master fan blade (sometimes referred to as a "gold standard" blade) for a particular fan blade embodiment, and using that primary master fan blade to produce a plurality of secondary master fan blades. The secondary master fan blades (sometimes referred to as "silver blades") may be used subsequently to produce fan blades (of that particular type) with moment weight data for use in new turbine engines and/or for use as replacement fan blades. In this manner, the present disclosure provides a method that utilizes relative inspection data and avoids the need to use absolute inspection data.

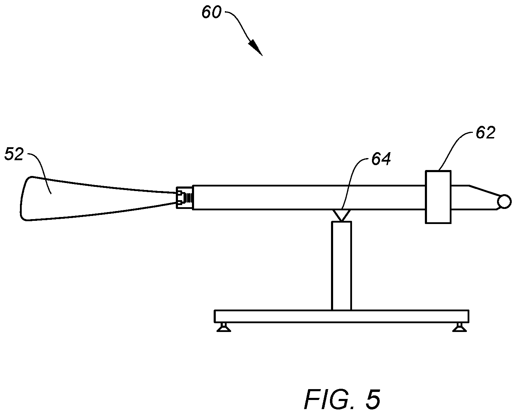

A primary master fan blade is selected that complies with all manufacturing parameters; e.g., dimensional data requirements, moment weight requirements, and the like. The selection of the primary master fan blade may include using multiple different metrological techniques for measuring the various different fan blade parameters to confirm the acceptability of the fan blade as a primary master fan blade. The moment weight value or values of the primary master fan blade and the weight of the primary master fan blade are recorded. The present disclosure is described herein in terms of three moment weigh values; i.e., radial, tangential, and axial moment weight values of a fan blade in the orthogonal planes (X, Y, and Z planes). In some instances, it may be acceptable to evaluate a fan blade (or other rotor blade) using less than all three moment weight values (e.g., radial, tangential, and axial). The present disclosure does not require use of all three moment weight values; e.g., a single moment weight value or a pair of moment weight values may be used in some instances. The parameter "moment weight" is a product of the weight of the fan blade multiplied by the distance between the center of rotation of the fan blade and the center of gravity of the fan blade. A moment weight value may be determined using a moment weight machine ("MWM"). FIG. 5 diagrammatically illustrates a moment weight machine. Generally speaking, a MWM 60 is a device that clamps the fan blade 52 in a particular manner/orientation, and utilizes counter weights 62 and a pivot point 64 disposed between the clamped fan blade and the counterweights to acquire the desired information. There are several different types of MWM's publicly available. For example, the MWM diagrammatically shown in FIG. 5 illustrates physical counterweights. In some MWMs, the counterweights are replaced by load cells or strain gauges, and associated electronics. The present disclosure is not limited to using any particular type of MWM. The present disclosure is not limited to any particular methodology for selecting a primary master fan blade.

To facilitate the description, the present disclosure is described herein in terms of a single primary master fan blade as the progenitor of secondary master fan blades, and therefore all of the fan blades that will be used in the field for a particular type of fan blade. In some instances, more than one primary master fan blade may be produced, and secondary master fan blades may be produced off of each primary master fan blade; i.e., more than one progenitor line. In these instances, to facilitate uniformity each of the primary master fan blades may be evaluated using the same metrological tools (e.g., a MWM, weight scale, etc.). To be clear, the present disclosure is described herein in terms of a single primary master fan blade as the progenitor of secondary master fan blades to facilitate the description, but the present disclosure is not limited to a single primary master fan blade as the progenitor.

The process of selecting secondary master fan blades may include initially selecting a plurality of secondary master fan blade candidates that comply with all manufacturing parameters; e.g., dimensional data requirements, moment weight requirements, and the like.

The process of selecting secondary master fan blades may further include evaluating the primary master fan blade on a given calibrated MWM to determine radial, tangential, and axial moment weight values for the primary master fan blade. In addition, the weight (i.e., the "pan weight") of the primary master fan blade is determined and may be used by the MWM during the determination of the moment weight values. The determination of the moment weight values using the given MWM may be performed multiple times to determine a body of measurement data that is sufficient to produce statistical data such as an average value. A maximum moment weight value and a minimum moment weight value may be identified for each of the radial, tangential, and axial moment weight values; e.g., a maximum and minimum values of the multiple measurements. For each moment weight value, the difference between the maximum and the minimum may be determined. Each difference between the maximum and the minimum may be compared to a predetermined threshold value for the respective type (radial, tangential, axial) of moment weight. If the max/min differences for each moment weight type are acceptable relative to the respective predetermined threshold value, the primary master fan blade and the MWM machine being used are considered to be acceptable. Offset values for each respective moment weight type (radial, tangential, axial) may then be determined by comparing the respective statistical value (e.g., average value, median value, or the like) and the respective moment weight recorded for the primary master fan blade. In this way, any variations associated with the MWM to be used for secondary master fan blade purposes can be identified. These offset values may be referred to as primary master fan blade offsets for the given MWM or "PMFB Offsets_{MWM}".

The process of selecting secondary master fan blades may further include evaluating a secondary master fan blade candidate on the given calibrated MWM to determine radial, tangential, and axial moment weight values for that secondary master fan blade candidate. The aforesaid moment weight value determinations may be performed multiple times to determine a body of measurement data that is sufficient to produce statistical data such as an average value, a median value, or the like. In addition, the weight (i.e., "pan weight") of that secondary master fan blade may be determined several times and included in the body of measurement data. A maximum moment weight value and a minimum moment weight value may be identified from the multiple measurements of the radial, tangential, and axial moment weight values. For each moment weight value, the difference between the maximum and the minimum may be determined; e.g., by subtraction of the minimum from the maximum. Each difference between the maximum and the minimum may be compared to a predetermined threshold value for the respective type (radial, tangential, axial) of moment weight. If the max/min differences for each moment weight type are acceptable relative to the respective predetermined threshold value, the secondary master fan blade candidate is considered to be acceptable. Calibration values for that specific secondary master fan blade candidate may then be determined using the offset values determined for the primary master fan blade (i.e., the "PMFB Offsets_{MWM}") and the statistical (e.g., average, median, etc.) values for the respective type (radial, tangential, axial) of moment weight. The weight of the secondary master fan blade candidate may be selected as the average of all the weight measurements of that secondary master fan blade candidate and included as a calibration value. The secondary master fan blade candidate with its noted calibration values (e.g., moment weights and weight) may be used subsequently as a secondary master fan blade.

To verify that the MWM did not drift or otherwise deviate from a calibrated state, the evaluation process described above for the primary master fan blade may be repeated and the results compared to the original results. Evaluation results that are within a predetermined threshold are indicative of the MWM still being calibrated after the secondary master fan blade calibration. The present disclosure does not require this verification step.

Alternatively, or in addition, to verify that the MWM did not drift or otherwise deviate from a calibrated state, the evaluation process described above for the secondary master fan blades may be repeated and the results compared to the original results. Evaluation results that are within a predetermined threshold are indicative of the MWM still being calibrated after the secondary master fan blade calibration. The present disclosure does not require this verification step.

Within the present disclosure methodology, each secondary master blade may be used to produce fan blades with moment weigh data for use in new turbine engines and/or for use as replacement fan blades. More specifically, a secondary master blade may be used to calibrate a moment weight machine that is used to produce a fan blade with moment weigh data. A non-limiting example of how the calibration may be performed includes measuring a radial moment weight value for the secondary master fan blade, an axial moment weight value for the secondary master fan blade, and /or a tangential moment weight value for the secondary master fan blade. The measured moment weight values may then be compared to the secondary master fan blade calibration values. If the measured moment weight values are within a predetermined tolerance of the respective moment weight values within the calibration values, then the moment weight machine may be deemed to be acceptable. If the measured moment weight values are not within the aforesaid tolerances, then the moment weight machine may be adjusted until it is within tolerance. For increased certainty, the process of producing measured moment weight values of the secondary master fan blade and comparison to calibration values may be repeated several times.

Once the calibration of the moment weight machine is verified, a fan blade with moment weight data may be produced by measuring the radial moment weight value, the axial moment weight value, and the tangential moment weight value of the fan blade using the calibrated moment weight machine. The pan weight of the fan blade is also determined. The measured radial moment weight value, axial moment weight value, tangential moment weight value, and pan weight of the fan blade may then be compared against a threshold value. If all of the measurements are within the threshold, then the fan blade may be deemed to be acceptable. The measured radial moment weight value, axial moment weight value, tangential moment weight value, and pan weight of the fan blade are recorded (e.g., marked on the blade) for subsequent use.

In some instances, a fan blade for use in a new turbine engine and/or for use as a replacement fan blade may satisfy all applicable tolerances including moment weight values, but may be closer to a tolerance value (e.g., a maximum or minimum permissible value) than other fan blades. In these instances, the manufacturer may modify the fan blade (e.g., either removing material or adding material in strategic locations) to cause the fan blade to be closer to specification values. In this manner, the modified fan blade may facilitate the balancing of a rotor stage. Fan blades having a significant size (e.g., radial height, chord, and the like) and weight may have larger tolerance ranges. In these instances, modify the fan blade (e.g., either removing or adding material) to cause the fan blade to be closer to specification values may be particularly useful.

Using the present disclosure methodology, all of the fan blades for a particular type of fan blade may be evaluated and provided with moment weigh data based off of a particular fan blade (e.g., a secondary master fan blade) and the calibration values for that secondary fan blade are based off of a particular fan blade (i.e., a primary master fan blade). Hence, for balancing purposes, the calibration values (e.g., moment weights and weight) for the fan blade are relative to the primary and secondary master fan blades; i.e., they may be described as being correlated to the primary and secondary master fan blades. This is in contrast with some existing practices that utilize fan blades that are measured and their moment weight values are determined on an individual / absolute basis. Moreover, the moment weight values of these individual fan blades may be determined on different MWMs potentially calibrated using different techniques. The present disclosure methodology provides a significant improvement in moment weight data consistency and moment weight machine calibration.

When a fan blade rotor stage is initially assembled, fan blade data (e.g., moment weight data, pan weight data, etc.) is used in the process of locating the fan blades circumferentially around the fan blade hub. For example, a pair of fan blades having similar fan blade data (e.g., moment weight data, pan weight data, etc.) may be disposed circumferentially opposite one another to enhance the balance of the fan blade rotor stage. Using the present disclosure methodology, the fan blade data (e.g., moment weight data, pan weight data, etc.) for each fan blade correlates back to a single fan blade (i.e., the primary master fan blade). Consequently, the fan blade data is understood to be inherently less variable and the fan blade rotor stage balancing improved.

The present disclosure methodology of producing secondary master fan blades also provides a mechanism for calibrating MWMs located at various different locations where fan blades are inspected and/or measured prior to use. Under the present disclosure methodology, a MWM may be calibrated (e.g., in a manner described above) using a secondary master fan blade, and/or the calibration of an MWM can be evaluated using a secondary master fan blade. A person of skill in the art will recognize the extreme sensitivity of MWMs and the need to verify calibration and/or recalibrate MWMs on a regular basis. Depending on the location and environment, the need to verify calibration and/or recalibrate a MWM may occur on a daily basis, or multiple times during a day. The secondary master fan blades provide a tool that can be used within the present disclosure methodology for such verification / calibration that correlates back to the primary master fan blade for increased consistency.

The present disclosure methodology is described in terms of a primary master fan blade and a secondary master fan blade. As described above, the primary master fan blade(s) and the secondary master fan blade(s) are used as tools in the production of fan blades for use in a new turbine engine and/or for use as a replacement fan blade. In some embodiments, the "primary master fan blade" and/or the "secondary master fan blade" may in fact not be an actual fan blade (i.e., one that may be used in an engine) but rather may be a tool that replicates a fan blade; e.g., a tool that replicates the moment weights (e.g., radial, tangential, and axial) and pan weight of a fan blade. In some instances, such a tool may be configured to permit an operator to adjust the moment weights and the pan weight replicated by the tool to very accurate standards. An adjustable tool that can be used to replicate a rotor blade may provide an enhanced ability to increase the balance of a production rotor stage.

While the principles of the disclosure have been described above in connection with specific apparatuses and methods, it is to be clearly understood that this description is made only by way of example and not as limitation on the scope of the disclosure. Specific details are given in the above description to provide a thorough understanding of the embodiments. However, it is understood that the embodiments may be practiced without these specific details.

It is noted that the embodiments may be described as a process which is depicted as a flowchart, a flow diagram, a block diagram, etc. Although any one of these structures may describe the operations as a sequential process, many of the operations can be performed in parallel or concurrently. In addition, the order of the operations may be rearranged. A process may correspond to a method, a function, a procedure, a subroutine, a subprogram, etc.

The singular forms "a," "an," and "the" refer to one or more than one, unless the context clearly dictates otherwise. For example, the term "comprising a specimen" includes single or plural specimens and is considered equivalent to the phrase "comprising at least one specimen." The term "or" refers to a single element of stated alternative elements or a combination of two or more elements unless the context clearly indicates otherwise. As used herein, "comprises" means "includes." Thus, "comprising A or B," means "including A or B, or A and B," without excluding additional elements.

It is noted that various connections are set forth between elements in the present description and drawings (the contents of which are included in this disclosure by way of reference). It is noted that these connections are general and, unless specified otherwise, may be direct or indirect and that this specification is not intended to be limiting in this respect. Any reference to attached, fixed, connected or the like may include permanent, removable, temporary, partial, full and/or any other possible attachment option.

No element, component, or method step in the present disclosure is intended to be dedicated to the public regardless of whether the element, component, or method step is explicitly recited in the claims. No claim element herein is to be construed under the provisions of 35 U.S.C. 112(f) unless the element is expressly recited using the phrase "means for." As used herein, the terms "comprise", "comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus.

While various inventive aspects, concepts and features of the disclosures may be described and illustrated herein as embodied in combination in the exemplary embodiments, these various aspects, concepts, and features may be used in many alternative embodiments, either individually or in various combinations and sub-combinations thereof. Unless expressly excluded herein all such combinations and sub-combinations are intended to be within the scope of the present application. Still further, while various alternative embodiments as to the various aspects, concepts, and features of the disclosures--such as alternative materials, structures, configurations, methods, devices, and components, and so on--may be described herein, such descriptions are not intended to be a complete or exhaustive list of available alternative embodiments, whether presently known or later developed. Those skilled in the art may readily adopt one or more of the inventive aspects, concepts, or features into additional embodiments and uses within the scope of the present application even if such embodiments are not expressly disclosed herein. For example, in the exemplary embodiments described above within the Detailed Description portion of the present specification, elements may be described as individual units and shown as independent of one another to facilitate the description. In alternative embodiments, such elements may be configured as combined elements. It is further noted that various method or process steps for embodiments of the present disclosure are described herein. The description may present method and/or process steps as a particular sequence. However, to the extent that the method or process does not rely on the particular order of steps set forth herein, the method or process should not be limited to the particular sequence of steps described. As one of ordinary skill in the art would appreciate, other sequences of steps may be possible.

## Claims

1. A method of producing a fan blade (52) with moment weight data, comprising:
providing a primary master fan blade (PMFB) having a recorded PMFB moment weight value and a recorded PMFB weight value;
using a moment weight machine (60) to determine a PMFB moment weight offset value for the primary master fan blade;
providing a secondary master fan blade (SMFB);
producing a SMFB statistical moment weight value using the moment weight machine;
producing SMFB calibration values for the secondary master fan blade using the PMFB moment weight offset value and the SMFB statistical moment weight value; and
using the SMFB calibration values and the secondary master fan blade to produce a fan blade with moment weight data.

2. The method of claim 1, wherein the step of using the SMFB calibration values and the secondary master fan blade to produce the fan blade with moment weight data includes using the SMFB calibration values and the secondary master fan blade to calibrate a second moment weight machine, and using the calibrated second moment weight machine to produce the fan blade with moment weight data.

3. The method of claim 2, wherein the step of using the calibrated second moment weight machine to produce the fan blade (FB) with moment weight data includes using the second moment weight machine to determine a radial FB moment weight value for the fan blade, an axial FB moment weight value for the fan blade, and a tangential FB moment weight value for the fan blade.

4. The method of claim 3, further comprising comparing the radial FB moment weight value to a first threshold, or comparing the axial FB moment weight value to a second threshold, or comparing the tangential FB moment weight value to a third threshold.

5. The method of any preceding claim, wherein the step of using the moment weight machine to determine the PMFB moment weight offset value includes using the moment weight machine to determine a plurality of measured PMFB moment weight values for the primary master fan blade, and producing a PMFB statistical moment weight value representative of the plurality of measured PMFB moment weight values.

6. The method of claim 5, wherein the plurality of measured PMFB moment weight values includes a plurality of measured PMFB radial moment weight values, a plurality of measured PMFB axial moment weight values, and a plurality of measured PMFB tangential moment weight values.

7. The method of claim 6, wherein the PMFB statistical moment weight value includes a first value representative of an average of the plurality of measured PMFB radial moment weight values, a second value representative of an average of the plurality of measured PMFB axial moment weight values, and a third value representative of an average of the plurality of measured PMFB tangential moment weight values.

8. The method of claim 5, 6 or 7, wherein the step of producing a SMFB statistical moment weight value includes using the moment weight machine to determine a plurality of measured SMFB moment weight values for the secondary master fan blade, and producing the SMFB statistical moment weight value using the plurality of measured SMFB moment weight values.

9. The method of claim 8, wherein the plurality of measured SMFB moment weight values includes a plurality of measured SMFB radial moment weight values, a plurality of measured SMFB axial moment weight values, and a plurality of measured SMFB tangential moment weight values.

10. The method of claim 9, wherein the SMFB statistical moment weight value includes a first value representative of an average of the plurality of measured SMFB radial moment weight values, a second value representative of an average of the plurality of measured SMFB axial moment weight values, and a third value representative of an average of the plurality of measured SMFB tangential moment weight values.

11. The method of claim 9 or 10, further comprising at least one of:
determining a maximum measured SMFB radial moment weight value from the plurality of measured SMFB radial moment weight values, a minimum measured SMFB radial moment weight value from the plurality of measured SMFB radial moment weight values, and a first difference value representative of a first difference between the maximum measured SMFB radial moment weight value and the minimum measured SMFB radial moment weight value, and comparing the first difference value to a first threshold value to determine an acceptability of the secondary master fan blade; or
determining a maximum measured SMFB axial moment weight value from the plurality of measured SMFB axial moment weight values, a minimum measured SMFB axial moment weight value from the plurality of measured SMFB axial moment weight values, and a second difference value representative of a second difference between the maximum measured SMFB axial moment weight value and the minimum measured SMFB axial moment weight value, and comparing the second difference value to a second threshold value to determine the acceptability of the secondary master fan blade; or
determining a maximum measured SMFB tangential moment weight value from the plurality of measured SMFB tangential moment weight values, a minimum measured SMFB tangential moment weight value from the plurality of measured SMFB tangential moment weight values, and a third difference value representative of a third difference between the maximum measured SMFB tangential moment weight value and the minimum measured SMFB tangential moment weight value, and comparing the third difference value to a third threshold value to determine the acceptability of the secondary master fan blade.

12. The method of any preceding claim, wherein the step of producing SMFB calibration values includes a weight value based on a measured weight of the secondary master fan blade.

13. The method of any preceding claim, further comprising using the secondary master fan blade to calibrate the moment weight machine.

14. A method of producing a fan blade (52) with moment weight data, comprising:
using a primary master fan blade (PMFB) having a recorded PMFB moment weight value and a recorded PMFB weight value and a first moment weight machine (60) to produce a secondary master fan blade (SMFB) with SMFB calibration values;
using the SMFB calibration values and the secondary master fan blade to calibrate a second moment weight machine; and
using the calibrated second moment weight machine to produce a fan blade with moment weight data,
wherein, optionally, the step of using the calibrated second moment weight machine to produce the fan blade (FB) with moment weight data includes using the second moment weight machine to determine a radial FB moment weight value for the fan blade, an axial FB moment weight value for the fan blade, and a tangential FB moment weight value for the fan blade,
wherein, further optionally, the method further comprises comparing the radial FB moment weight value to a first threshold, or comparing the axial FB moment weight value to a second threshold, or comparing the tangential FB moment weight value to a third threshold.

15. The method of any preceding claim, wherein:
the primary master fan blade is a tool that replicates a production fan blade; and/or
the secondary master fan blade is a tool that replicates a production fan blade.
